(19) Europäisches Patentamt

European Patent Office

Office européen des brevets

(11) Veröffentlichungsnummer: **0 152 550**
**B1**

(12) **EUROPÄISCHE PATENTSCHRIFT**

(45) Veröffentlichungstag der Patentschrift:
03.02.88

(21) Anmeldenummer: 84113775.5

(22) Anmeldetag: 14.11.84

(51) Int. Cl.⁴: **H 03 K 17/06**

(54) Verfahren und Vorrichtung zum Ansteuern des stromleitenden Zustandes eines abschaltbaren Thyristors.

(30) Priorität: 17.02.84 DE 3405769

(43) Veröffentlichungstag der Anmeldung:
28.08.85 Patentblatt 85/35

(45) Bekanntmachung des Hinweises auf die Patenterteilung:
03.02.88 Patentblatt 88/5

(84) Benannte Vertragsstaaten:
AT BE CH DE FR GB IT LI NL SE

(56) Entgegenhaltungen:
EP-A-0 064 450
US-A-3 617 810
US-A-3 728 557

IEEE TRANSACTIONS ON INDUSTRY
APPLICATIONS, Band IA-19, Nr. 3, Teil 1, Mai-Juni
1983, Seiten 335-342, New York, US; Y. MATSUDA
u.a.: "Development of PWM inverter employing
GTO"

(73) Patentinhaber: **Siemens Aktiengesellschaft Berlin
und München, Wittelsbacherplatz 2, D-8000
München 2 (DE)**

(72) Erfinder: **Peppel, Jörg- Michael, Dr., Heuhohlweg
10, D-6240 Königstein (DE)**

**Beschreibung**

Die Erfindung betrifft ein Verfahren zum Ansteuern des stromleitenden Zustandes eines über seine Gitteransteuerung abschaltbaren Thyristors (Abschaltthyristor "GTO"). Die Erfindung betrifft ferner eine zur Durchführung des Verfahrens geeignete Vorrichtung.

Thyristoren, die durch einen entsprechenden, ihrem Gitteranschluß aufgeschalteten Steuerstrom abgeschaltet werden können, ermöglichen einen bedeutend einfacheren Aufbau von Stromrichtern, Gleichstromstellern und anderen Geräten der Leistungselektronik als herkömmliche Thyristoren, die nur über einen Zündstrom einschaltbar sind und ihren stromführenden Zustand beibehalten, bis der von ihrer Anode zur Kathode fließende Strom auf natürliche Weise oder durch Anlegen einer Gegenspannung auf Null zurückgegangen ist und sie daher von selbst erlöschen.

Der leitende Zustand eines GTO-Thyristors wird also durch einen positiven Zündstromstoß auf dem Gitter eingeleitet, jedoch besteht - bedingt durch den inneren Aufbau dieser Thyristoren - die Gefahr, daß vor allem im Schwachlastfall (geringer Strom zwischen Anode und Kathode) die Thyristoren teilweise, d. h. in einem Teil ihres stromführenden Querschnittes, erlöschen und auch bei einem Wiederanstieg des Stromes nicht in den vollständigen leitenden Zustand zurückkehren. Ein derartig unvollständiger leitender Zustand kann dann zur Zerstörung des GTO führen. Es kann sogar der Fall auftreten, dan bei einem geringen Strom der Thyristor verlöscht und daher trotz eines an sich erwünschten leitenden Zustandes eine Stromsperre auftritt. Es ist daher auch nach einem ersten Zündimpuls für einen GTO-Thyristor noch erforderlich, diesen Thyristor zur Verhinderung eines teilweisen oder gänzlichen Verlöschens im Schwachlastfall entsprechend dem stromleitenden Zustand mit einem Zündstrom anzusteuern.

Hierzu könnte an sich während der gesamten Stromführungsdauer ein konstanter Steuerstrom oder eine fest vorgegebene Folge von Zündstrom-Impulsen auf den GTO gegeben werden. Dies bedeutet aber einen sehr hohen Energiebedarf, der im Schaltzyklus häufig den größten Teil der gesamten Steuerenergie ausmacht.

Aus der EP-A-0 064 450 ist bereits ein Verfahren und eine Vorrichtung zur Zündung eines Zweirichtungsthyristors (TRIAC) bekannt. Die Zündung wird dabei durch den Modulator freigegeben, der durch Anstoßen einer ersten monostabilen Kippstufe einen Zündimpuls vorgegebener Dauer auf die Zündelektrode des TRIAC legt. Ist nach Ablauf dieses Zündimpulses der TRIAC noch nicht vollständig stromleitend, so steigt dessen Anoden-Kathoden-Spannung erneut an. Überschreitet diese wiederkehrende Spannung innerhalb einer durch eine zweite monostabile Kippstufe vorgegebenen Zeitdauer einen maximal zulässigen Wert, welche durch einen Komparator überwacht wird, so wird die erste monostabile Kippstufe erneut angestoßen und ein weiterer Zündimpuls vorgegebener Dauer auf die Zündelektrode gegeben. Dieser Vorgang wiederholt sich zyklisch solange, wie innerhalb der durch die zweite monostabile Kippstufe bestimmten Zeitdauer durch den Komparator ein erneutes Überschreiten des maximal zulässigen Wertes der TRIAC-Spannung detektiert wird. Dieser Verfahren ermöglicht gegenüber der Zündung des Zweirichtungsthyristors mit einem Dauerzündimpuls eine Einsparung an Steuerenergie.

Der Erfindung liegt die Aufgabe zugrunde, das bekannte Verfahren für die Ansteuerung eines abschaltbaren Thyristors (GTO-Thyristor) weiter so zu verbessern, daß der stromleitende Zustand auf möglichst zuverlässige Weise bei minimalem Aufwand an Steuerenergie sichergestellt werden kann. Insbesondere soll die bereitgestellte Steuerenergie möglichst gut der zur Zündung bzw. der Aufrechterhaltung des stromführenden Zustandes des GTO-Thyristors tatsächlich benötigten Steuerenergie anpaßbar sein.

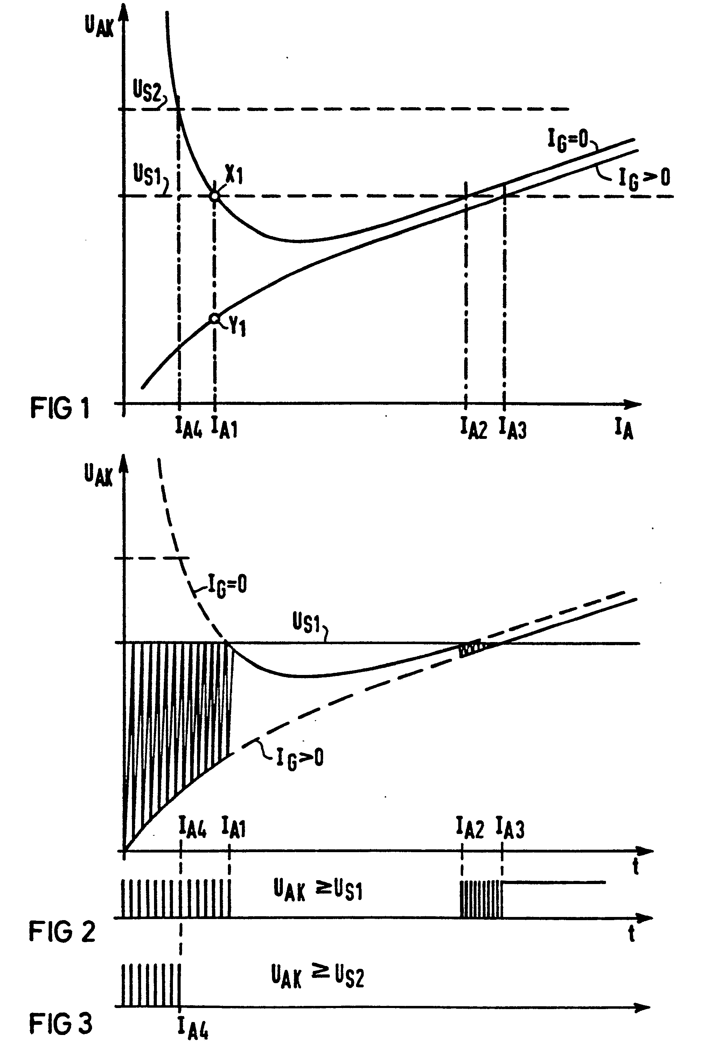

In Fig.1 sind die Kennlinien für die Anoden/Kathoden-Spannung $U_{AK}$ des Thyristors in Abhängigkeit von dem Laststrom $I_A$, der von Anode zur Kathode fließt, angegeben, wobei die durch $I_G = 0$ gegebene Kennlinie den Verlauf der Spannung $U_{AK}$ während des stromführenden Zustandes in dem Fall angibt, daß dem Gitter über längere Zeit kein Zündstrom $I_G$ zugeführt wird. $I_G > 0$ gibt den entsprechenden Verlauf der Spannung bei Aufschalten eines ausreichenden kontinuierlichen Zündstromes an.

Man entnimmt diesen Figuren, daß der Spannungsabfall $U_{AK}$ am Thyristor zu kleineren Lastströmen hin proportional zum Laststrom $I_A$ abnimmt und im Schwachlastfall bei Aufschalten eines Zündstromes ($I_G > 0$) etwas überproportional auf Null abfällt. Wird jedoch kein Zündstrom zugeführt, so kommt es bei weiter abnehmendem Laststrom $I_A$ - verbunden mit einem teilweisen Verlöschen des Thyristors - zu einem steilen Ansteigen des Spannungsabfalls $U_{AK}$, der schließlich bis auf die gesamte am Thyristor anliegende Spannung anwächst. Der Thyristor geht dann in den Sperrzustand über.

Die Erfindung geht nun von der Überlegung aus, daß es im Grunde nicht nötig ist, während der gesamten Stromführungsdauer einen Dauerimpuls bereitzustellen, sondern daß es genügt, jeweils dann einen Impuls abzugeben, wenn der Spannungsabfall einen vorgegebenen Schwellwert, z. B. $U_{S1}$, erreicht. Bei einem Laststrom $I_{A1}$ kann die Spannung $U_{AK}$ ohne Zündstrom bis zu dem auf der Kennlinie $I_G = 0$ liegenden Punkt $X_1$ ansteigen. Bei $U_{AK} = U_{S1}$ geht durch einen positiven Steuerstrom $I_g$ der Spannungsabfall auf den auf der Kennlinie $I_G > 0$ liegenden Wert $Y_1$ zurück, gleichzeitig werden auch die bereits erloschenen Bereiche des Thyristorquerschnittes wieder gezündet. Wird beim Unterschreiten des Grenzwertes $U_{S1}$ der Zündstrom weggenommen, so steigt die Spannung erneut an, bis es beim Erreichen des Schwellwertes $U_{S1}$ erneut zu einem Zündstrom-Impuls kommt. Daher entsteht im Schwachlastfall anstelle eines Dauerstromes nunmehr eine Impulskette. Für $I_A < I_{A1}$ steigt dabei die Spannung nicht mehr bis zur stationären Kennlinie $I_G = 0$ an, vielmehr wird der Zündimpuls jeweils bereits bei $U_{AK} = U_{S1}$ abgegeben und es kommt ebenfalls zu einer Kette von aufeinanderfolgenden Zündstromimpulsen.

In Figur 2 ist diese Impulskette für den Fall dargestellt, daß der Laststrom stetig hochgefahren wird. Für niedrige Lastströme wechseln also Zustände ohne Zündstrom, bei denen die Spannung unter dem Schwellwert $U_{S1}$ liegt, mit Zuständen ab, bei denen der Schwellwert überschritten und der Zündstrom eingeschaltet ist. Die in Figur 2 dargestellte Impulskette beschreibt also ein Oszillieren der Thyristorspannung $U_{AK}$ zwischen dem oberen Grenzwert $U_{S1}$ und einem durch die Kennlinie $I_G > 0$ gegebenen unteren Grenzwert.

Übersteigt der Laststrom $I_A$ den Wert $I_{A1}$, bei dem die obere Kennlinie die durch $U_{S1}$ gegebene Gerade schneidet, so steigt die Thyristorspannung selbst ohne Zündstrom nicht mehr auf den Schwellwert $U_{S1}$ an; es kommt daher zu keinen Zündungen mehr. Erst für Lastströme über $I_{A2}$ kann die Thyristorspannung wieder den Schwellwert $U_{S1}$ erreichen, für diesen Hochlastfall ergeben sich also wieder Zündstrom-Impulse entsprechend einer zwischen $U_{S1}$ und der unteren Kennlinie oszillierenden Thyristorspannung. Beim Wert $I_{A3}$ schließlich übersteigt selbst bei anliegendem Zündstrom ($I_G > 0$) die Thyristorspannung den Schwellwert $U_{S1}$; daher entsteht für $I_A > I_{A3}$ nunmehr ein Dauerimpuls.

Dieses Verfahren bedingt gegenüber der Ansteuerung mit konstantem Dauer-Zündstrom im Bereich $I_{A1} < I_A < I_{A2}$ wegen des Wegfalls der Steuerimpulse keine Steuerverluste. Der Dauerimpuls bei $I_A > I_{A3}$ hingegen bedeutet einen unnötigen Verbrauch an Steuerenergie, da in diesem Lastbereich an sich kein teilweises Verlöschen des GTO zu befürchten ist. Diese Verluste könnten zwar dadurch verringert werden, daß der Schwellwert (entsprechend dem in Figur 1 ebenfalls dargestellten Wert $U_{S2}$) höher gewählt wird, so daß sich anstelle der Figur 2 beim kontinuierlichen Hochfahren des Laststromes nunmehr eine Impulskette entsprechend Figur 3 ergibt. Eine Erhöhung des Schwellwertes bewirkt jedoch, daß nunmehr der durch $U_{AK} = U_{S2}$ gegebene Schnittpunkt $I_{A4}$ bereits in einem Bereich mit sehr unvollständig leitenden Zuständen liegt, verbunden mit unerwünscht hohen Durchlaßspannungen des GTO, und der bereits erwähnten Gefahr der Thyristorzerstörung. Ein Betrieb mit dem hohen Grenzwert $U_{S2}$ ist daher in der Regel nicht sicher und somit unzulässig.

Hinzu kommt, daß der Zündstrom jeweils nach den Erfordernissen der Zündung bemessen werden muß, während an sich zur Aufrechterhaltung des leitenden Zustandes mittels eines kontinuierlichen Zündstromes nur ein geringerer Strom erforderlich ist. Dadurch ergeben sich einerseits für $I_A > I_{A3}$ beim Verfahren nach Figur 1 und Figur 2 höhere Stromverluste als bei einem Dauerzündstrom, und auch im Bereich $I_A < I_{A1}$ stellen die Zündstrom-Impulse gegenüber dem Dauerstrom keine optimale Energieersparnis dar.

Ferner wird bei diesem Verfahren die Dauer eines Stromimpulses von der Ansprechdauer eines Grenzwertmelders für $U_{AK} \geqslant U_{S1}$ bestimmt. Schaltet aber der GTO in einem Lastkreis mit geringer oder nahezu stromloser Induktivität, so bricht seine Anodenspannung augenblicklich auf einen niedrigen Wert zusammen, wodurch der Steuerstrom sofort unterbrochen wird. Dies kann zu einer unzulässigen Verkürzung des Zündimpulses führen.

Diese Nachteile können vermieden werden durch ein Verfahren gemäß den Merkmalen des Anspruchs 1.

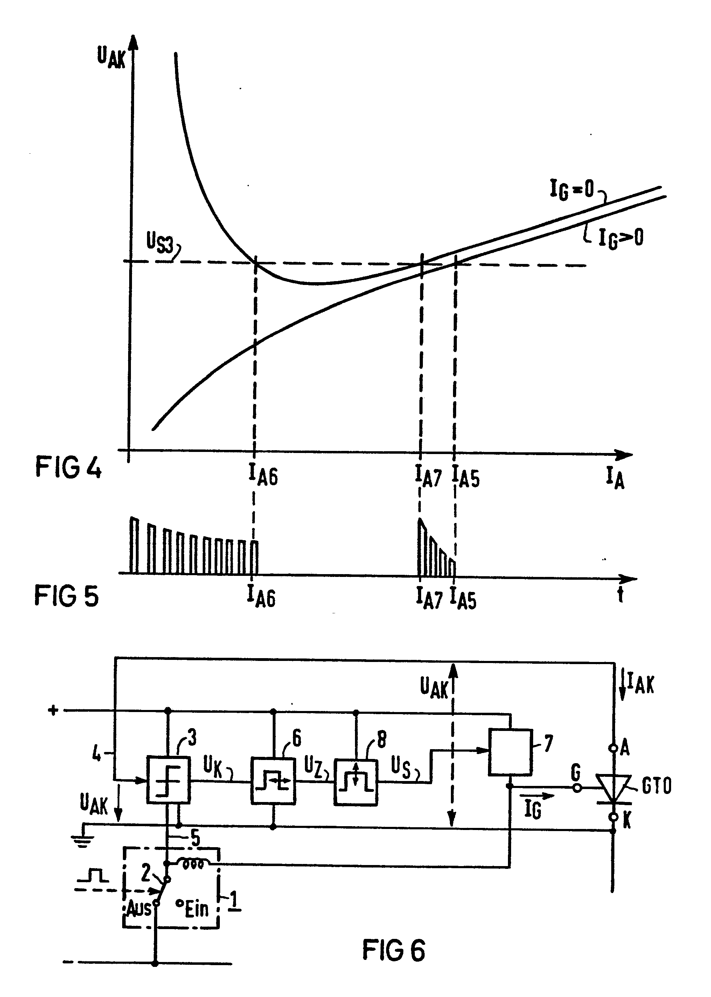

Dieses Verfahren ist in Bild 4 dargestellt. Dabei wird der Spannungsabfall $U_{AK}$ am Thyristor erfaßt und jeweils beim Erreichen eines vorgegebenen Schwellwertes $U_{S3}$ ein einzelner Zündstrom-Impuls auf das Thyristorgitter gegeben, wobei aber die Höhe und Dauer dieses Impulses nunmehr vorgegeben ist. Man erkennt an der (den Figuren 2 und 3 für diesen Fall entsprechenden) Zündimpulskette nach Figur 5, daß nunmehr im Bereich $I_A > I_{A5}$, in dem die Thyristorspannung $U_{AK}$ stets über dem Schwellwert $U_{S3}$ liegt, kein Zündimpuls mehr entsteht. Vielmehr wird der letzte, in seine Länge begrenzte, Zündimpuls abgegeben, wenn bei Hochfahren des Laststromes $I_A$ die untere Kennlinie den Schwellwert $U_{S3}$ erreicht. Dadurch ergibt sich im Hochlastfall eine bedeutende Einsparung an Steuerenergie. Dann kann auch der Schwellwert $U_{S3}$ so niedrig gelegt werden, daß bei einem für $I_G = 0$ durch $U_{AK} = U_{S3}$ gegebenen Schnittpunkt $I_{A6}$ nunmehr der Bereich $I_A < I_{A6}$ praktisch alle unvollständig leitenden Zustände erfaßt. Innerhalb dieses Bereiches wird also durch die dargestellte Impulskette stets der vollständig leitende Zustand wieder hergestellt, so daß sich das Risiko der Zerstörung des GTO durch unvollständig leitende Zustände beträchtlich verringert, ohne daß im Hochlastbereich große Energieverluste entstehen können. Lediglich im Bereich $I_{A7} < I_A < I_{A5}$ entstehen beim Hochfahren des Laststroms noch einige, an sich unnötige Zündstrom-Impulse.

In Figur 5 ist ferner angedeutet, daß die Höhe des Zündstromes während eines Einzelimpulses und bei verschiedenen Lastströmen nicht konstant ist. Vielmehr wird vorteilhaft die Höhe des Zündstromes während eines Einzelimpulses, insbesondere gegen Ende des Impulses, heruntergesteuert. Dies entspricht der bereits erwähnten Tatsache, daß zum Zünden des Stromes zwar ein relativ hoher Zündstrom benötigt, aber zur Aufrechterhaltung eines leitenden Zustandes nur ein geringerer Steuerstrom erforderlich ist. Es wird also nach dieser bevorzugten Weiterbildung der Erfindung die Kurvenform eines Impulses dem jeweils benötigten Zünd- bzw. Steuerstrom vorgegeben.

Eine weitere Energieersparnis ergibt sich, wenn die Höhe und ggf. auch die Dauer des Zündstrom-Impulses in Abhängigkeit vom Abstand vom vorangegangenen Zündstrom-Impuls vorgegeben wird. Folgen die Zündstrom-Impulse rasch aufeinander, so wird auch nur ein entsprechend geringerer Zündstrom benötigt und die Höhe des Zündstrom-Impulses wird daher entsprechend geringer vorgegeben.

Anhand eines bevorzugten Ausführungsbeispieles und 4 weiterer Figuren wird eine vorteilhafte Vorrichtung zur Durchführung des Verfahrens in Weiterbildung der Erfindung näher erläutert.

Figur 6 zeigt im Blockdiagramm den Aufbau der Vorrichtung, Figur 7 stellt die Schaltung einer Eingangsstufe und einer Komparatorstufe dar, die Figuren 8 und 9 zeigen den Aufbau einer Impulsdauer-Begrenzungsstufe bzw. einer Impulshöhe-Begrenzungsstufe und einer gesteuerten Stromquelle zur Aufschaltung des Zündstrom-Impulses auf das Gitter des Thyristors.

In Figur 6 ist mit A, K und G der Anoden-, Kathoden- und Gitter-Anschluß des GTO gezeigt. Einer Eingangsstufe 1 wird mittels eines Schaltimpulses der Befehl zum Einschalten und Aufrechterhalten des stromführenden Zustands des GTO gegeben. Bei der schematischen Darstellung in Figur 6 ist dies dadurch angedeutet, daß mittels des Einschaltimpulses ein Schalter 2 geöffnet wird, der im geschlossenen Zustand (Thyristorsperre) eine negative Speisespannung von z. B. -12 V auf das Gitter G schaltet. Gleichzeitig wird durch den Einschaltimpuls auch eine Komparatorstufe 3 aktiviert, die einerseits an eine Betriebsspannung (z. B. +12 V) angelegt ist und der der Spannungsabfall $U_{AK}$ zugeführt ist. Die Komparatorstufe 3 gibt nun ein Komparatorsignal $U_K$ ab, sobald der erfaßte Spannungsabfall des Thyristors im leitenden Zustand einen vorgegebenen Grenzwert überschreitet.

Das Komparatorsignal $U_K$ wird durch eine Impulsdauer-Begrenzungsstufe 6 in einen auf eine unabhängig vom Komparatorzustand vorgegebene Dauer begrenzten Zündbefehl $U_Z$ umgesetzt. Dieser Zündbefehl kann länger oder kürzer sein als der Zustand $U_{AK} > U_{S1}$.

Dieser Zündbefehl dient zur Steuerung einer steuerbaren Stromquelle 7, die den Zündstrom-Impuls $I_G$ mit der durch den Zündbefehl gegebenen Dauer auf das Gitter G schaltet. Zwischen der Impulsdauer-Begrenzungsstufe 6 und der gesteuerten Stromquelle 7 ist vorteilhaft noch eine Impulshöhen-Begrenzungsstufe 8 angeordnet. Die Stufen 6, 7 und 8 sind dabei ebenfalls an die Speisespannung, im Beispiel also +12 V, angeschlossen.

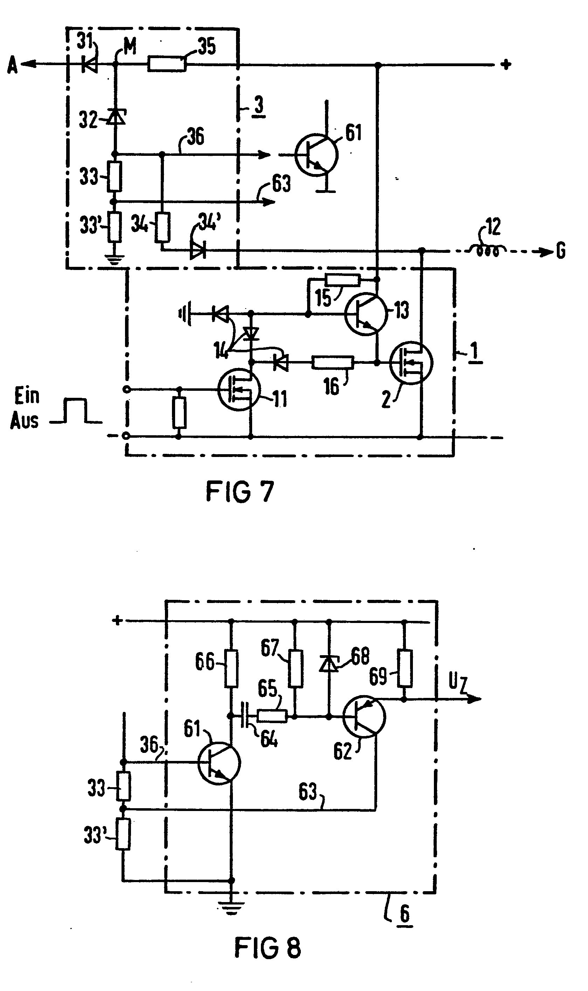

Figur 7 zeigt, daß in der Eingangsstufe 1 das Steuersignal "Aus" zunächst einen Feldeffekttransistor 11 sperrt, so daß der über eine Diodenschaltung 14 angeschlossene Transistor 13 leitend wird und einen weiteren FET, der als Schalter 2 dient, leitend steuert. Dieser weitere Feldeffekttransistor 2 ist zwischen einem negativen Potential von z. B. -12 V und dem GTO-Gitter G angeordnet, wobei dem Gitteranschluß zur Einschalthilfe eine Induktivität 12 vorgeschaltet sein kann. Durch diese Ansteuerung wird der Schalter 2 (Figur 6) geschlossen, wenn durch das Ansteuersignal "Aus" der Sperrzustand des GTOs herbeigeführt werden soll. Dadurch wird letztlich die Spannung -12 V als Sperrspannung einerseits dem Thyristorgitter G, andererseits auch der Basis des später erläuterten Transistors 61 aufgeschaltet, der der Auslösung eines Zündbefehls dient und dessen Basis am Abgriff 36 eines Spannungsteilers für den Spannungsabfall des GTO angeschlossen ist. Dieser Transistor 61 wird daher schnell ausgeräumt und gesperrt, wenn durch das Steuersignal "Aus" eine Thyristorsperre angesteuert wird. Mit 15, 16 sind die Widerstände für die Beschaltung dieser Transistoren dargestellt.

Die Komparatorschaltung 3 enthält einen über eine Diode 31 an den Anodenanschluß A angeschlossene Zenerdiode 32, die einerseits zusammen mit Widerständen 33, 33' einen Spannungsteiler mit dem Abgriff 36 darstellt, andererseits über einen Widerstand 34 und eine Diode 34' in der dargestellten Weise an den Gitteranschluß G angeschlossen ist. Beim Schaltsignal "Aus" (FET 2 leitend) ist damit der Abgriff 36 auf negativem Potential und der Komparator inaktiviert. Bei gesperrtem GTO (d. h. durchgesteuertem FET 2) liegt der Spannungsteiler 32, 34 zwischen der Betriebsspannung +12 V und der Sperrspannung -12 V, die Diode 34' ist leitend und die Zenerdiode 32 bricht durch. Am Abgriff 36 zwischen Zenerdiode 32 und Widerstand 33 liegt dabei als Komparatorsignal eine negative Spannung an, entsprechend einer sperrenden Basissteuerung des später erläuterten Transistors 61 in der Impulsdauer-Begrenzungsstufe 6.

Ist dagegen der Schalter 2 geöffnet und liegt am GTO eine hohe Thyristorspannung an, so sperrt die Diode 31, deren Anode am Punkt M sowohl mit dem Spannungsteiler 32, 33, 33' wie auch über einen Widerstand 35 mit der Betriebsspannung (z. B. +12 V) verbunden ist. Das nunmehr am Punkt M anliegende positive Potential führt zum Durchbruch der Zenerdiode 32 und am Abgriff 36 liegt ein Potential an, das durch die Dimensionierung des Zweiges 35, 32, 33, 33' bestimmt ist und so gewählt ist, daß einerseits über den Abgriff 36 ein Basisstrom zum Transistor 61 fließen kann, andererseits die bei diesen hohen Thyristorspannungen $U_{AK}$ auftretende Gitter/Kathodenspannung des GTO die Spannung am Abgriff 36 übersteigt und die Diode 34' sperrt.

In diesem Fall ($U_{AK}$ groß) entsteht also ein Komparator-Dauersignal, das aber nicht zu einer Dauerversorgung des Thyristorgitters mit Zündstrom ausgenutzt wird, sondern nur die nachfolgende Impulsdauer-Begrenzungsstufe anstößt. Das Komparatorsignal tritt aber nicht erst dann auf, wenn die Anodenspannung über das Potential am Punkt M steigt und die Diode 31 sperrt. Vielmehr erhält der Abgriff 36 (und damit der Steueranschluß des Transistors 61) bereits dann Strom, wenn die Anodenspannung zwar noch so niedrig ist, daß die Diode 31 leitet, aber am Punkt M bereits eine Spannung erzeugt, die zum Durchbruch der Zenerdiode 32 führt. Der das Komparatorsignal auslösende Spannungsgrenzwert ist also durch die Dimensionierung des Spannungsteilers 32, 33, 33' bestimmt.

Dabei ist besonders vorteilhaft, daß ein Einschaltsignal "Ein" nicht sofort zwangsläufig über die einzelnen Stufen der Vorrichtung zu einem Zündstrom-Impuls für den GTO führt. In der Stromrichter-Technik tritt nämlich häufig der Fall auf, daß antiparallel zu einem Thyristor eine Diode angeordnet ist, über die eine extern angelegte negative Spannung einen Strom treibt. Bei einer Umkehr der treibenden Spannung muß dann erst abgewartet werden, bis der Strom über die Diode soweit abgeklungen ist, daß sich an den Thyristoranschlüssen eine genügend positive Spannung ausbilden kann und ein Einschaltimpuls tatsächlich zu einer Thyristorzündung führt. Wird aber der Zündimpuls nach einem Steuerprogramm ohne Rücksicht auf derartige Verzögerungen gebildet, so entstehen unnötige Zündströme, die die Steuerschaltung und das die Steuerschaltung speisende Netzgerät belasten. Bei der geschilderten Schaltung wird dagegen nur dann ein Komparatorsignal erzeugt und ein Zündimpuls ausgelöst, wenn die Thyristorspannung tatsächlich einen für eine erfolgreiche Thyristorzündung ausreichenden Wert erreicht hat.

Der Abgriff 36 liefert also nur dann als Komparatorsignal einen positiven Steuerstrom für einen nachgeschalteten Transistor, wenn einerseits durch ein dem eingeschalteten GTO entsprechendes Steuersignal der Schalter 2 geöffnet ist, andererseits die Anodenspannung einen durch die Betriebsspannung, die Durchbruchspannung der Zenerdiode und die Dimensionierung der Widerstände gegebenen Grenzwert erreicht oder überschreitet.

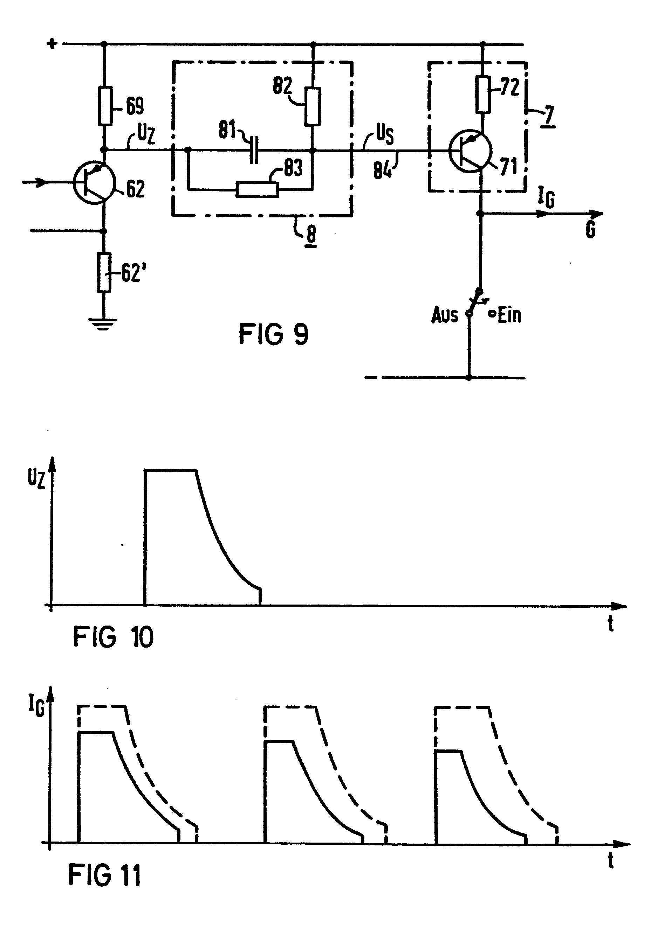

Die in Figur 8 dargestellte Impulsdauer-Begrenzungsstufe 6 ist ebenfalls von der positiven Betriebsspannung gegenüber der (in diesem Falle an Masse angeschlossenen) Kathodenspannung gespeist und enthält einen ersten Transistor 61, der von dem am Abgriff 36 anstehenden Komparatorsignal gesteuert ist, sowie einen zweiten Transistor 62. Die Basis des ersten Transistors ist über eine Mitkopplungsleitung 63 mit einem Mitkopplungswiderstand (in der dargestellten Schaltung ist der Widerstand 33 auch als Mitkoppelungswiderstand verwendet) mit einem Anschluß des zweiten Transistors und die Basis des zweiten Transistors 62 ist über einen Kondensator 64, der in der angegebenen Weise mit Widerständen 65, 66, 67 und einer weiteren Zenerdiode 68 beschaltet ist, an den ersten Transistor gekoppelt. Sobald der Transistor 61 aufgrund eines entsprechenden Steuerstromes leitend wird, fließt über den Widerstand 66 sowie den dazu parallelen Zweig 64, 65, 67 ein entsprechender Transistorstrom aus der Speisespannungsquelle. Dadurch ändert sich der Ladungszustand des Kondensators 64, der anfangs entladen war und sich nun mit der Zeitkonstante seines Lade- und Entladenetzwerkes 65, 66, 67, 68 auflädt. Solange der Kondensator noch wenig aufgeladen ist, liegt dadurch an der Basis des zweiten Transistors 62 eine verhältnismäßig niedrige, durch die Zenerdiode 68 begrenzte Spannung an. Dieser Transistor wird daher ebenfalls leitend und bewirkt einen Stromfluß über seine Widerstandsbeschaltung 69, 33', wodurch gleichzeitig über die Mitkopplungsleitung 63 Steuerstrom auf die Basis des ersten Transistors 61 fließt. Dadurch wird der erste Transistor 61 auch dann noch leitend gehalten, wenn sich das Komparatorsignal ändert und der Abgriff 36 keinen Steuerstrom mehr führt. Der Strom durch den Transistor 62 nimmt jedoch in dem Maße ab, in dem sich der Ladungszustand des Kondensators 64 exponentiell seinem aufgeladenen Endzustand nähert. Der Transistor 61 wird dadurch zumindest bis zum Erreichen des Spannungsendwertes am Kondensator 64 im leitenden Zustand gehalten. Liegt aufgrund eines andauernden Komparatorsignals am Spannungseingang 36 auch dann noch Steuerstrom vor, so führt zwar der Transistor 61 weiterhin Strom, jedoch sperrt der zweite Transistor 62, sobald der Kondensator 64 bis auf volle Kondensatorspannung aufgeladen ist und über ihn kein Basisstrom zum Transistor 62 mehr fließen kann.

Folglich erlischt mit Erreichen des Endzustandes der Kondensatorladung der durch den zweiten Transistor 62 fließende Strom. Am Widerstand 69 führt diese Ansteuerung des Transistors 62 dazu, daß jeweils mit der Ansteuerung des Transistors 61 zunächst ein hoher Spannungsabfall anliegt, der dann aber mit der Zeitkonstanten des Kondensatornetzwerkes 64, 65, 66, 67 abnimmt. Dauer und Höhe dieses als Zündbefehl abgreifbaren Spannungssignals ist damit unabhängig davon, ob das Komparatorsignal am Eingang 36 nach Auslösen des Zündbefehls noch anhält oder verschwindet.

Der Aufbau der Impulsdauer-Begrenzungsstufe 6 kann auf verschiedene Weise variiert werden. So kann z. B. der Kondensator 64 und sein Netzwerk auch parallel zum Transistor 61 geschaltet werden, so daß er sich bei gesperrtem Transistor 61 auflädt und bei gezündetem Transistor entlädt. Dann ist der Transistor 62 so anzusteuern, daß er bei aufgeladenen Kondensator 64 sperrt, mit Einschalten des Transistors 61 leitend wird und im leitenden Zustand verbleibt, bis der Kondensator 64 ganz entladen ist. Bei entsprechender Anordnung kann der Transistor 61 auch durch ein derartiges Signal am Spannungsabgriff 36 gesteuert werden, daß er im Ruhezustand (d. h. solange das Komparatorsignal eine unter dem Schwellwert liegende Thyristorspannung anzeigt) leitend ist und erst dann über eine entsprechende Ansteuerung des zweiten Transistors am Ausgang der Begrenzungsstufe 6 ein Spannungssignal auslöst, wenn er bei Erreichen des Schwellwertes in sperrendem Zustand übergeht.

Wie Figur 9 zeigt, wird das am Widerstand 69 der Begrenzerstufe 6 abgegriffene Spannungssignal in der Impulshöhen-Begrenzungsstufe 8 über einen Kondensator 81 geführt, der zusammen mit seinem Widerstandsnetzwerk 82, 83 eine Ladezeitkonstante aufweist, die erheblich über der die Zündbefehl-Dauer begrenzenden Zeitkonstanten des Kondensatornetzwerkes 61, 64, 65, 66, 67, 68 liegt. Dadurch wird erreicht, daß am Ausgang 84 dieser Impulshöhen-Begrenzungsstufe 8 ein Steuersignal anliegt, das nur dann die volle Höhe des Zündbefehlsignals erreicht, wenn sich der Kondensator 81 seit Auftreten des letzten Zündbefehls vollkommen entladen hat. Eine bei kürzeren Zündbefehl-Abständen noch vorhandene Restladung (entsprechend einer Gleichspannungskomponente in der Zündbefehls-Kette) am Kondensator 81 führt dagegen zu einer entsprechenden Reduzierung der Impulshöhe am Ausgang 84.

Der Steuerausgang 84 liefert somit ein Signal, das direkt zur Steuerung des Stromes aus der Stromquelle 7 verwendet werden kann. Hierzu ist der Steuereingang 84 mit der Basis eines weiteren, mit einem Vorwiderstand 72 versehenen Transistors 71 verbunden, der zwischen der Betriebsspannungsquelle und dem Gitteranschluß G liegt.

Figur 10 zeigt den Verlauf eines einzelnen Zündbefehls, wie er beim Anstoß der Impulsdauer-Begrenzungsstufe erzeugt wird und der Impulshöhe-Begrenzungsstufe zugeführt wird. Der Impuls steigt dabei zunächst beim Auftreten eines Komparatorsignals schlagartig auf ein Spannungs-Plateau an, das von dem Ladestrom des Kondensators 64 hervorgerufen und von der Durchbruchspannung der Zenerdiode 68 begrenzt ist (Figur 8).

Nach Erlöschen der Zenerdiode 68 lädt sich der Kondensator 64 nur noch über den Widerstand 67 mit einem exponentiell abklingenden Strom auf. Da dieser Ladestrom den Basisstrom für den Transistor 62 liefert, wird auch der Strom durch den Transistor 62 und den Widerstand 69 bzw. der über das Kondensatornetzwerk 81, 83 fließende Steuerstrom (Zündbefehl) mit dem gleichen Kurvenverlauf heruntergesteuert, bis die Mitkopplung zusammenbricht und der Transistor 62 ganz erlischt.

Die Kurvenform nach Figur 10 wird verändert, wenn während eines Zündstrom-Impulses vom "Ein"-Signal in das "Aus"-Signal (Figur 7) übergegangen wird. Da dabei der FET 2 augenblicklich gezündet und dadurch der Transistor 61 gesperrt wird, wird der Zündstrom sofort unterbrochen, unabhängig vom Zustand des Komparatorsignals.

Liegt dagegen bei einem "Ein"-Signal ein Komparator-Dauersignal an, so wird der Zündbefehl nicht durch den Zusammenbruch der Mitkopplung beendet, vielmehr wurd durch den ständig leitenden Transistor 61 der Transistor 62 in dem Maße leitend gehalten, in dem der Ladestrom des Kondensators 64 exponentiell bis auf die volle Betriebsspannung aufgeladen wird, was in manchen Fällen vorteilhaft sein kann.

In Figur 11 sind einige Zündstrom-Impulse $I_G$ einer Impulskette dargestellt, wobei die gestrichelten Linien den in Figur 10 gezeigten Kurvenverlauf im Falle eines isolierten Einzelimpulses darstellt. Gegenüber dem Einzelimpuls ist die Impulsdauer dadurch verkürzt, daß der Kondensator 64 sich in den Pausen zwischen zwei Zündbefehlen über sein Widerstandsnetzwerk 65, 66, 67 nicht mehr vollständig entladen kann.

Andererseits wird bei jedem Zündbefehl der Kondensator 81 der Impulshöhen-Begrenzungsstufe aufgeladen und kann sich ebenfalls in den Pausen nur pausendauerabhängig entladen. Dadurch entsteht am Kondensator 81 eine Gleichspannungskomponente, die zwar die Bildung der Zündbefehle kaum beeinflußt, aber die Steuerspannung $U_S$ für den Steuertransistor 71 der steuerbaren Stromquelle 7 reduziert und somit die Höhe der Zündstrom-Impulse ebenfalls pausendauerabhängig heruntersteuert.

Diese Kurvenform und ihre Anpassung an die Häufigkeit der Impulse kommen den für eine quasikontinuierliche Ladungszufuhr vorgegebenen Anforderungen an den Zündstrom recht nahe.

Bei dieser Schaltung können auch dann, wenn der GTO auf eine stromlose Lastinduktivität schaltet, die eingangs erwähnten Schwierigkeiten nicht auftreten, da Höhe, Verlauf und Dauer des Zündimpulses durch die Schaltung vorgegeben sind. Für den Bedarf an Zündenergie kann man aus Figur 5 ablesen, daß im Bereich $I_A > I_{A5}$ kein Zündstrom erzeugt wird, daher der Energiebedarf hier sehr gering ist. Im schmalen Bereich $I_{A5} > I_A > I_{A7}$ treten an sich unnötige Zündströme auf, die sich noch durch eine laststromabhängige Zündimpulssperre vermeiden lassen, falls der damit verbundene Schaltungsaufwand angesichts dieses schmalen Bereiches noch wirtschaftlich ist. Die im Schwachlastfall ($I_A < I_{A6}$) auftretenden Zündstrom-Impulsketten sind in Impulshöhe und -dauer weitgehend optimiert. Bei einem praxisnahen Schaltspiel beträgt daher der Energiebedarf nur bis etwa 25 % des Energiebedarfs einer Ansteuerung mit konstantem Zündstrom. Da der Schaltungsaufwand zwar höher als bei einer Dauerzündstrom-Ansteuerung ist, aber vor allem im Hochlastfall eine bedeutende Energieeinsparung vorliegt, ist diese Schaltung vor allem bei Stromrichtergeräten hoher Leistung und ähnlichen Anwendungsfällen vorteilhaft, in denen für längere Zeit im Hochlastbetrieb gearbeitet werden muß und ein hoher Steuerenergie-Bedarf der verwendeten GTO den Aufwand für deren Ansteuerschaltungen in die Höhe treibt.

Für den Vergleich zur Impulskette nach Figur 2 ergeben sich ähnliche Verhältnisse, wenn der Schwellwert $U_{S1}$ vergleichbar niedrig gewählt ist. Ein hoher Schwellwert $U_{S2}$ mit Impulsketten entsprechend Figur 3 ist wegen des erhöhten Risikos einer GTO-Zerstörung bei unvollständig leitenden Thyristorzuständen häufig ohnehin nicht realisierbar. Die Vermeidung unnötiger Zündstrom-Impulse (Bereich $I_A > I_{A5}$) sowie die reduzierte Impulshöhe einer Impulskette sind dabei auch im Hinblick darauf vorteilhaft, daß die Erzeugung von Impulsketten an sich eine unangenehm pulsierende Belastung der Betriebsspannungs-Versorgung für die Ansteuerschaltungen darstellt.

## Patentansprüche

1. Verfahren zum Ansteuern eines über eine Gitterelektrode (G) abschaltbaren Thyristors (GTO) in den stromleitenden Zustand, dadurch gekennzeichnet, daß

a) der Spannungsabfall ($U_{AK}$) am Thyristor (GTO) erfaßt wird,

b) ein Zündstrom-Impuls ($I_G$) ausgelöst und an die Gitterelektrode (G) angelegt wird, wenn der Spannungsabfall ($U_{AK}$) am Thyristor einen vorgegebenen Schwellenwert ($U_{S3}$) erreicht,

c) der Zündstrom-Impuls beendet wird nach einer Dauer, welche unabhängig ist vom weiteren Verlauf des Spannungsabfalles nach dem Auslösen des Zündstrom-Impulses, und

d) die Höhe und die Dauer des Zündstrom-Impulses ($I_G$) abhängig vom zeitlichen Abstand zum vorangegangenen Zündstrom-Impuls vorgegeben werden.

2. Verfahren nach Anspruch 1, dadurch gekennzeichnet, daß die Höhe des Zündstrom-Impulses vor dessen Beendigung reduziert wird.

3. Vorrichtung zum Ansteuern eines über eine Gitterelektrode (G) abschaltbaren Thyristors (GTO) in den stromleitenden Zustand, gekennzeichnet durch

a) eine Komparatorstufe (3), die ein Komparatorsignal ($U_K$) abgibt, sobald der Spannungsabfall ($U_{AK}$) am Thyristor (GTO) einen vorgegebenen Schwellenwert erreicht,

b) eine Impulsdauer-Begrenzungsstufe (6), die bei Auftreten eines Komparatorsignales ($U_K$)

einen Zündbefehl ($U_Z$) bildet, dessen Dauer vom zeitlichen Abstand zum vorangegangenen Zündbefehl abhängig ist,

c) eine Impulshöhen-Begrenzungsstufe (8), welche die Höhe des Zündbefehles ($U_Z$) abhängig vom zeitlichen Abstand zum vorangegangenen Zündbefehl begrenzt und eine entsprechende Steuerspannung ($U_S$) abgibt, und

d) eine steuerbare Stromquelle (7), welche die Steuerspannung ($U_S$) umsetzt in einen entsprechenden Zündstrom-Impuls ($I_G$) für die Gitterelektrode (G) des Thyristors (Figur 6).

4. Vorrichtung nach Anspruch 3, gekennzeichnet durch eine Eingangsstufe (1), welche beim Auftreten eines Befehles zum Ansteuern des Thyristors in den stromleitenden Zustand die Komparatorstufe (3), die steuerbare Stromquelle (7) und den abschaltbaren Thyristor (GTO) aktiviert (Figur 6).

5. Vorrichtung nach Anspruch 3 oder 4, dadurch gekennzeichnet, daß die Komparatorstufe (3) einen eine Zenerdiode (32) enthaltenden Spannungsteiler (32, 33) für die Thyristorspannung ($U_{AK}$) und einen Abgriff (36) enthält, über den bei Erreichen der Durchbruchspannung der Zenerdiode ein das Komparatorsignal ($U_K$) bildender Steuerstrom in die Impulsdauer-Begrenzungsstufe (6) fließt (Figur 7).

6. Vorrichtung nach Anspruch 4, dadurch gekennzeichnet, daß die Eingangsstufe (1) einen Schalter (2) enthält, der bei einem Sperrsignal dem Thyristorgitter (G) und der am Abgriff eines Spannungsteilers (35, 33, 33') für die Thyristorspannung angeschlossenen Basis eines den Zündbefehl auslösenden ersten Transistors (61) eine Sperrspannung aufschaltet (Figur 7).

7. Vorrichtung nach Anspruch 3 oder 4, dadurch gekennzeichnet, daß die Impulsdauer-Begrenzungsstufe (6) von einer Speisespannung (+12 V) gespeist ist, an die ein an seiner Basis vom Komparatorsignal gesteuerter erster Transistor (61) und eine zweiter Transistor (62) angeschlossen ist, und daß die Basis des ersten Transistors (61) über eine Mitkopplung (63) an den zweiten Transistor und die Basis des zweiten Transistors (62) über ein Kondensatornetzwerk (64 bis 68) an den ersten Transistor derart gekoppelt sind, daß ein vom Komparatorsignal ($U_K$) angesteuerter Zustand des ersten Transistors (61) einerseits am Kondensatornetzwerk eine Kondensatorspannungsänderung bis zu einem durch das Netzwerk vorgegebenen Spannungsendwert bewirkt, wobei die Kondensatorspannungsänderung den zweiten Transistor zum Erzeugen des Zündbefehls ($U_Z$) ansteuert, andererseits der erste Transistor (61) durch den von der Kondensatorspannungsänderung angesteuerten Zustand des zweiten Transistors (62) zumindest bis zum Erreichen des Spannungsendwertes in dem vom Komparatorsignal ausgelösten Zustand gehalten wird (Figur 8).

8. Vorrichtung nach Anspruch 3 oder 4, dadurch gekennzeichnet, daß der Impulsdauer-Begrenzungsstufe (6) eine Impulshöhen-Begrenzungsstufe (8) mit einem zweiten, mittels des Zündbefehls ($U_Z$) aufladbaren Kondensatornetzwerk (81, 82, 83) nachgeschaltet ist, wobei die Kondensatorspannung des zweiten Kondensatornetzwerkes sich während des Abstandes zwischen zwei Zündbefehlen mit einer durch das Netzwerk vorgegebenen Zeitkonstante ändert, die über der in der Impulsdauer-Begrenzungsstufe eingestellten Impulsdauer liegt, und wobei die Kondensatorspannung während eines Zündbefehls ($U_Z$) die Stromstärke der steuerbaren Stromquelle (7) zur Erzeugung des Zündstrom-Impulses ($I_G$) als Steuerspannung ($U_S$) beeinflußt (Figur 9).

**Claims**

1. A method of driving into the current conducting state a thyristor (GTO) which can be disconnected via a grid electrode (G), characterised in that

a) the voltage drop ($U_{AK}$) across the thyristor (GTO) is detected;

b) an ignition current pulse ($I_G$) is triggered and applied to the grid electrode (G) when the voltage drop ($U_{AK}$) across the thyristor reaches a given threshold value ($U_{S3}$);

c) the ignition current pulse is terminated after a period of time which is independent of the further course of the voltage drop following the triggering of the ignition current pulse; and

d) the level and duration of the ignition current pulse ($I_G$) are predetermined independently of the interval of time from the preceding ignition current pulse.

2. A method as claimed in Claim 1, characterised in that the level of the ignition current pulse is reduced prior to its termination.

3. A device for driving into the current conducting state a thyristor (GTO) which can be disconnected via a grid electrode (G), characterised by:

a) a comparator stage (3) which emits a comparator signal ($U_K$) as soon as the voltage drop ($U_{AK}$) across the thyristor (GTO) reaches a predetermined threshold value;

b) a pulse duration limiting stage (6) which forms an ignition command ($U_Z$) on the occurrence of a comparator signal ($U_K$), the duration of which ignition command is dependent upon the interval of time from the preceding ignition command;

c) a pulse level limiting stage (8) which limits the level of the ignition command ($U_Z$) in dependence upon the interval of time from the preceding ignition command and which emits a corresponding control voltage ($U_S$); and

d) a controllable current source (7) which converts the control voltage ($U_S$) into a corresponding ignition current pulse ($I_G$) for the grid electrode (G) of the thyristor (Fig. 6).

4. A device as claimed in Claim 3, characterised by an input stage (1) which activates the comparator stage (3), the controllable current source (7) and the disconnectible thyristor (GTO) on the occurrence of a command to drive the thyristor into the current conducting state (Fig. 6).

5. A device as claimed in Claim 3 or Claim 4, characterised in that the comparator stage (3) contains a voltage divider (32, 33), which comprises a Zener diode (32) for the thyristor voltage ($U_{AK}$) and a tapping (36) through which a control current, which forms the comparator signal ($U_K$), flows into the pulse duration limiting stage (6) when the break-through voltage of the Zener diode is reached (Fig. 7).

6. A device as claimed in Claim 4, characterised in that the input stage (1) contains a switch (2) connected to the tapping of a voltage divider (35, 33, 33') for the thyristor voltage which applies a blocking voltage to the thyristor grid (G) and to the base of a first transistor (61) which triggers the ignition command in the event of a blocking signal (Fig. 7).

7. A device as claimed in Claim 3 or Claim 4, characterised in that the pulse duration limiting stage (6) is supplied with a supply voltage (+12 V) applied to a first transistor (61), which is controlled across its base by the comparator signal, and to a second transistor (62), and that the base of the first transistor (61) is coupled via a positive feedback (63) to the second transistor, and the base of the second transistor (62) is coupled via a capacitor network (64 to 68) to the first transistor, such that on the one hand state of the first transistor (61) produced by the comparator signal ($U_K$) effects a change in the capacitor voltage of the capacitor network until it reaches a terminal voltage value predetermined by the network, where the change in capacitor voltage causes the second ttransistor to generate the ignition command ($U_Z$), and on the other hand the state of the second transistor (62) which results from the change in the capacitor voltage maintains the first transistor (61) in the state triggered by the comparator signal, at least until the terminal voltage value is reached (Fig. 8).

8. A device as claimed in Claim 3 or Claim 4, characterised in that the pulse duration limiting stage (6) is connected at its output to a pulse level limiting stage (8) comprising a second capacitor network (81, 82, 83) which can be charged by the ignition command ($U_Z$), where, during the interval between two ignition commands, the capacitor voltage of the second capacitor network changes with a time constant which is predetermined by the network and which exceeds the pulse duration set in the pulse duration limiting stage, and where, during an ignition command ($U_Z$), the capacitor voltage influences the current level of the controllable current source (7) which generates the ignition current pulse ($I_G$) from the control voltage ($U_S$) (Fig. 9).

## Revendications

1. Procédé pour commander la mise à l'état conducteur d'un thyristor (GTO) pouvant être bloqué par l'intermédiaire d'une électrode de grille (G), caractérisé par le fait que

a) la chute de tension ($U_{AK}$) aux bornes du thyristor (GTO) est détectée,

b) une impulsion de courant d'amorçage ($I_G$) est déclenchée et est appliquée à l'électrode de grille (G) lorsque la chute de tension ($U_A$) aux bornes du thyristor atteint une valeur de seuil prédéterminée ($U_{S3}$),

c) l'impulsion de courant d'amorçage est arrêtée au bout d'une durée qui est indépendante de la variation ultérieure de la chute de tension après le déclenchement de l'impulsion de courant d'amorçage, et

d) l'amplitude et la durée de l'impulsion de courant d'amorçage ($I_G$) sont prédéterminées en fonction de la distance dans le temps par rapport à l'impulsion de courant d'amorçage précédente.

2. Procédé suivant la revendication 1, caractérisé par le fait que l'amplitude de l'impulsion de courant d'amorçage est réduite avant son interruption.

3. Dispositif pour commander la mise à l'état conducteur d'un thyristor (GTO) pouvant être bloqué au moyen d'une électrode de grille (G), caractérisé par

a) un étage comparateur (3), qui délivre un signal ($U_K$) dès que la chute de tension ($U_{AK}$) aux bornes du thyristor (GTO) atteint une valeur de seuil prédéterminée,

b) un étage (6) de limitation de la durée de l'impulsion, qui, lors de l'apparition d'un signal ($U_K$) délivré par le comparateur, forme une commande d'amorçage ($U_Z$), dont la durée dépend de la distance dans le temps par rapport à la commande d'amorçage précédente,

c) un étage (8) de limitation de l'amplitude des impulsions, qui limite l'amplitude de l'instruction d'amorçage ($U_Z$) en fonction de la distance dans le temps par rapport à l'instruction d'amorçage précédente et délivre une tension de commande correspondante ($U_S$), et

d) une source de courant commandable (7), qui convertit la tension de commande ($U_S$) en une impulsion correspondante de courant d'amorçage ($Q_G$) pour l'électrode de grille (G) du thyristor (figure 6).

4. Dispositif suivant la revendication 3, caractérisé par un étage d'entrée (1) qui, lors de l'apparition d'une instruction pour la commande du thyristor à l'état conducteur, déclenche l'étage comparateur (3), la source de courant commandable (7) et le thyristor blocable (GTO) (figure 6).

5. Dispositif suivant la revendication 3 ou 4, caractérisé par le fait que l'étage comparateur (3) contient un diviseur de tension (32, 33), contenant une diode Zener (32), pour la tension ($U_{AK}$) aux bornes du thyristor et une prise (36), au moyen de laquelle un courant de commande constituant le signal ($U_K$) délivré par le comparateur pénètre dans l'étage (6) de limitation de la durée des impulsions, lorsque la tension de claquage de la diode Zener est atteinte (figure 7).

6. Dispositif suivant la revendication 4, caractérisé par le fait que l'étage d'entrée (1) contient un interrupteur (2) qui, lors de la présence d'un signal de blocage, applique une tension de blocage à la grille (G) du thyristor et à la base, raccordée à la prise d'un diviseur de tension (35, 33, 33') pour la tension du thyristor, d'un premier transistor (61) déclenchant la commande d'amorçage (figure 7).

7. Dispositif suivant la revendication 3 ou 4, caractérisé par le fait que l'étage (6) de limitation de la durée des impulsions est alimenté par une tension d'alimentation (+12 V), qui est appliquée à un premier transistor (61) commandé par le signal du comparateur, appliqué à sa base, et un second transistor (69), et que la base du premier transistor (61) est couplée par l'intermédiaire d'une branche de réaction (62) au second transistor et la base du second transistor (62) est couplée par l'intermédiaire d'un réseau à condensateurs (64 à 68) au premier transistor de telle sorte que d'une part un état du premier transistor (61), commandé par le signal ($U_K$) délivré par le comparateur, déclenche dans le réseau à condensateurs une variation de la tension aux bornes du condensateur jusqu'à une valeur terminale de tension prédéterminée par le réseau, la variation de tension aux bornes du condensateur commandant le second transistor pour qu'il produise l'instruction d'amorçage ($U_Z$), et que d'autre part le premier transistor (61) est maintenu, par l'état du second transistor (62), commandé par la variation de la tension aux bornes du condensateur, dans l'état déclenché par le signal délivré par le comparateur, et ce au moins jusqu'à ce que la valeur finale de tension soit atteinte (figure 8).

8. Dispositif suivant la revendication 3 ou 4, caractérisé par le fait qu'en aval de l'étage (6) de limitation de la durée des impulsions se trouve branché un étage (8) de limitation de l'amplitude des impulsions, muni d'un second réseau à condensateurs (81, 82, 83), qui peut être chargé au moyen de l'instruction d'amorçage ($U_Z$), auquel cas la tension aux bornes du condensateur du second réseau à condensateurs varie pendant l'intervalle de temps s'étendant entre deux instructions d'amorçage avec une constante de temps prédéterminée qui est prédéterminée par le réseau et qui est supérieure à la durée des impulsions réglée dans l'étage de limitation de la durée des impulsions, et la tension aux bornes du condensateur influe, pendant une instruction d'amorçage ($U_Z$), sur l'intensité du courant de la source de courant commandable (7) pour produire l'impulsion de courant d'amorçage ($I_G$) en tant que tension de commande ($U_S$) (figure 9).

0 152 550

FIG 1

FIG 2

FIG 3

1

FIG 4

FIG 5

FIG 6

3

FIG 7

FIG 8

FIG 9

FIG 10

FIG 11